# FASCICULE DE BREVET EUROPEEN

(11) **EP 3 503 143 B1**
(45) Date de publication et mention de la délivrance du brevet: **27.05.2020**
(21) Numéro de dépôt: 18213774.5
(22) Date de dépôt: 18.12.2018
(51) Int. Cl.: H01G 11/06, H01G 11/28, H01G 11/68, H01G 11/70, H01G 11/84, H01C 10/10, H01M 4/66, H01M 10/0562

(54) **RÉALISATION D'UN COLLECTEUR DE DISPOSITIF MICROÉLECTRONIQUE**
HERSTELLUNG EINES KOLLEKTORS FÜR EINE MIKROELEKTRONISCHE VORRICHTUNG
PRODUCTION OF A COLLECTOR FOR MICROELECTRONIC DEVICE

(30) Priorité: 21.12.2017 FR 1762742
(43) Date de publication de la demande: 26.06.2019
(73) Titulaire: Commissariat à l'Energie Atomique et aux Energies Alternatives, 75015 Paris (FR)
(72) Inventeur: DUBARRY, Christophe, 38640 CLAIX (FR); ZANELLATO, Olivier, 73000 CHAMBERY (FR)
(74) Mandataire: Decobert, Jean-Pascal

(56) Documents cités:
- EP-A1- 1 032 064
- EP-A1- 1 746 674
- EP-A1- 2 192 638
- FR-A1- 3 028 088
- JP-A- H09 306 505
- US-A1- 2012 043 120
- US-B1- 6 671 165

## Description

### DOMAINE DE L'INVENTION

La présente invention concerne les dispositifs microélectroniques disposant de parties d'électrode et de collecteur de courant, par exemple dans le domaine du stockage d'énergie par voie électrochimique, mais aussi par exemple dans les empilements à couche active comme des couches piezoélectriques, notamment pour la réalisation de capteurs ou d'actionneurs.

L'invention trouve pour application avantageuse, mais non limitative, la fabrication de dispositifs microélectroniques. Par dispositif microélectronique, on entend tout type de dispositif réalisé avec les moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...).

Un intérêt spécifique non limitatif de l'invention est la réalisation de dispositifs de stockage d'énergie électrochimique. Cela inclut notamment les dispositifs du type batterie, accumulateur ou condensateur utilisant un électrolyte.

### ARRIERE-PLAN TECHNOLOGIQUE

En se référant notamment aux systèmes de stockage d'énergie électrochimique, ceux-ci sont de manière générale réalisés par des dépôts successifs sur un substrat d'un premier collecteur de courant, d'une première électrode, d'un électrolyte ou conducteur ionique, d'une deuxième électrode, et d'un deuxième collecteur de courant. Une encapsulation, par le biais de dépôt de couches supplémentaires, ou par report de capot, est souvent nécessaire pour protéger le système de la réactivité chimique avec l'oxygène et la vapeur d'eau. Un tel dispositif microélectronique est décrit dans le document EP 2 192 638 A1.

La migration d'un ou plusieurs ions entre les deux électrodes à travers l'électrolyte permet soit de stocker de l'énergie ou de la délivrer vers un circuit externe.

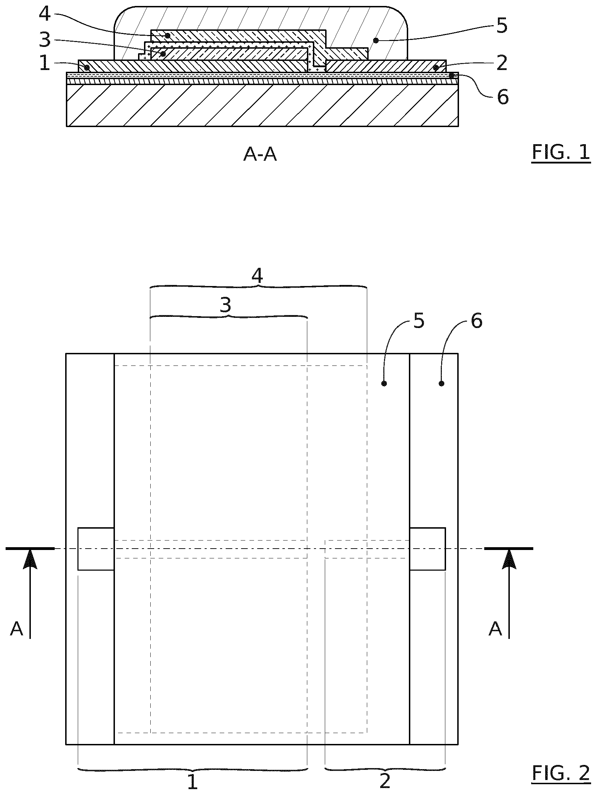

Plus précisément, comme l'illustrent les figures 1 et 2, ce type de système est réalisé sur un substrat (par exemple en verre ou en silicium) et comprend en empilement : une couche isolante 6 si le substrat est électriquement conducteur, un premier collecteur de courant 1, une première électrode 3, un électrolyte ou conducteur ionique, une deuxième électrode 4, et un deuxième collecteur de courant 2. La figure 1 montre aussi une encapsulation réalisée par une couche isolante électronique 5 et, éventuellement, une encapsulation par une couche métallique finale. En figure 2, les collecteurs de courant 1, 2, raccordés chacun à l'une différente des électrodes, sont accessibles par l'extérieur de l'empilement du dispositif de stockage électrochimique, pour une reprise de contact. La première électrode 3 (ou électrode positive utilisée dans un accumulateur au lithium ou sodium conventionnel) est potentiellement utilisable dans une microbatterie et les exemples de matériaux sont d'ailleurs nombreux, comme : LiCoO₂, V₂O₅, TiS₂, LiMn₂O₄, NaMnO₂, NaCoO₂...

L'électrolyte solide ou matériaux super-ionique à base de verre sont parmi les meilleurs candidats pour les électrolytes solides inorganiques applicables à toute batterie tout-solide. Il a été développé un grand choix de sulfure et systèmes vitreux d'électrolyte d'oxysulfure, ainsi qu'une série de verre-céramique super-ionique de sulfure Li₂S-P₂S₅, dont la conductivité d'ion de Li⁺ est comparable à celle des électrolytes liquides. En ce qui concerne l'électrolyte pour les batteries au sodium, il existe la même famille de verre, par exemple Na₃PS₄.

Ce type de composant présente l'inconvénient d'avoir au moins une étape à fort budget thermique durant son procédé technologique. Notamment, dans le cas des matériaux évoqués précédemment pour la formation de la première électrode, on réalise généralement une oxydation thermique sous air ou sous dioxygène dont la finalité est de cristalliser le matériau de la première électrode ; fréquemment, les températures de ce traitement thermique sont comprises entre 500 et 700°C. Cette particularité conditionne des spécifications restrictives sur le premier collecteur de courant. En effet, le collecteur de courant doit conserver ses propriétés de conduction électrique après un traitement à température élevée sous une atmosphère oxydante. De manière conventionnelle, le matériau utilisé est le platine, matériau onéreux mais capable de conserver ses propriétés de conduction électrique après le traitement thermique de par son oxydabilité quasi nulle. Lorsque d'autres matériaux sont employés, la dégradation de l'efficacité du dispositif microélectronique est importante à cause de l'oxydation des parties conductrices induite par le traitement thermique. EP 1 746 674 A1 décrit une couche protectrice contre l'oxydation d'un collecteur de courant dans une batterie.

Il existe donc actuellement un besoin pour une fabrication améliorée de dispositifs comprenant une partie de collecteur et une partie d'électrode portées par un substrat. C'est un objet de l'invention que de pallier au moins en partie les inconvénients des techniques actuelles pour y parvenir.

### RESUME DE L'INVENTION

Le procédé de réalisation d'un dispositif microélectronique selon l'invention est défini par les caractéristiques de la revendication 1. Le procédé comprend successivement :
- une formation d'un premier collecteur de courant sur une face d'un substrat ;
- une formation d'une première électrode sur, et en continuité électrique avec, une portion du premier collecteur de courant ;
- un traitement thermique configuré pour traiter la première électrode.

Avantageusement, la formation du premier collecteur de courant comprend une formation d'une première couche de collecteur sur la face du substrat et une formation d'une deuxième couche de collecteur recouvrant au moins une partie, dite partie recouverte, de la première couche de collecteur et présentant une première face au contact de la première électrode, la deuxième couche de collecteur est configurée pour protéger la partie recouverte durant le traitement thermique, de sorte que le traitement thermique n'oxyde pas ladite partie recouverte.

L'approche de l'invention propose une nouvelle structure de collecteur de courant comprenant deux parties ; une partie électriquement conductrice constituée d'un matériau de conductivité électronique élevée et une deuxième partie, superposée à la première, servant de protection à l'oxydation.

La constitution d'un tel empilement se justifie par la volonté de séparer les fonctions de la conduction électronique et de la résistance à l'oxydation. En effet, il est proposé de réaliser un empilement qui permettra de protéger la fonction de conduction électronique pendant les étapes à budget thermique important utilisées pour la cristallisation ou l'optimisation de la première électrode. Suivant un aspect, l'invention permet de limiter ou d'éviter le recours à des matériaux onéreux, en particulier le platine, souvent utilisé comme matériau de collecteur du fait de son caractère inoxydable.

Le dispositif microélectronique selon l'invention est défini par les caractéristiques de la revendication 12. Le dispositif comprend en empilement sur une face d'un substrat un premier collecteur de courant, une première électrode, une couche active, une deuxième électrode et un deuxième collecteur de courant, caractérisé par le fait que le premier collecteur comprend une première couche de collecteur au contact de la face du substrat et une deuxième couche de collecteur recouvrant au moins une partie, dite partie recouverte, de la première couche de collecteur et présentant une première face au contact de la première électrode et en ce que la deuxième couche de collecteur est configurée pour protéger la partie recouverte contre l'oxydation

### BREVE INTRODUCTION DES FIGURES

D'autres caractéristiques, buts et avantages de la présente invention apparaitront à la lecture de la description détaillée qui suit, en regard des dessins annexés, donnés à titre d'exemples, non limitatifs, et sur lesquels :
- La FIGURE 1 illustre en coupe suivant l'épaisseur du substrat un exemple de dispositif de stockage électrochimique selon l'état de la technique ;
- La FIGURE 2 en montre une vue de dessus ;
- les FIGURES 3 à 9 présentent des étapes successives d'un mode de réalisation non limitatif de l'invention.

Les dessins sont donnés à titre d'exemples et ne sont pas limitatifs de l'invention.

Ils constituent des représentations schématiques de principe destinées à faciliter la compréhension de l'invention et ne sont pas nécessairement à l'échelle des applications pratiques. En particulier, les épaisseurs relatives des couches ne sont pas représentatives de la réalité.

### DESCRIPTION DETAILLEE

Il est précisé que, dans le cadre de la présente invention, le terme « sur » ou « au-dessus » ne signifie pas obligatoirement « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant, soit directement à son contact, soit en étant séparée d'elle par un film, ou encore une autre couche ou un autre élément. Une couche peut par ailleurs être composée de plusieurs sous-couches d'un même matériau ou de matériaux différents.

Il est précisé que dans le cadre de la présente invention, l'épaisseur d'une couche ou du substrat se mesure selon une direction perpendiculaire à la surface selon laquelle cette couche ou ce substrat présente son extension maximale.

Certaines parties du dispositif de l'invention peuvent avoir une fonction électrique. Certaines sont employées pour des propriétés de conduction électrique et on entend par électrode, collecteur ou équivalent, des éléments formés d'au moins un matériau ayant une conductivité électrique suffisante, dans l'application, pour réaliser la fonction souhaitée. À l'inverse, on entend par isolant électrique ou diélectrique un matériau qui, dans l'application, assure une fonction d'isolation électrique.

Selon l'invention, on réalise un dispositif microélectronique comprenant pour le moins, sur un substrat, un premier collecteur de courant est une première électrode. Au sens de la présente demande, le terme collecteur s'entend d'une partie du dispositif ayant pour fonction de raccorder une électrode un élément extérieur au dispositif, c'est-à-dire situé à l'extérieur de l'empilement de couches du dispositif, généralement encapsulé. Le terme électrode s'entend quant à lui d'une partie du dispositif en continuité électrique avec une couche active (en particulier un électrolyte, de préférence solide, pour le cas du stockage électrochimique ou encore une couche piézoélectrique par exemple). Le collecteur de courant est raccordé à son électrode de sorte à établir une continuité électrique entre ces deux parties ; ces dernières peuvent en outre être issues d'une ou plusieurs couches communes de matériaux ; dans ce cas, le collecteur formera généralement une excroissance de l'électrode, vers l'extérieur du dispositif encapsulé.

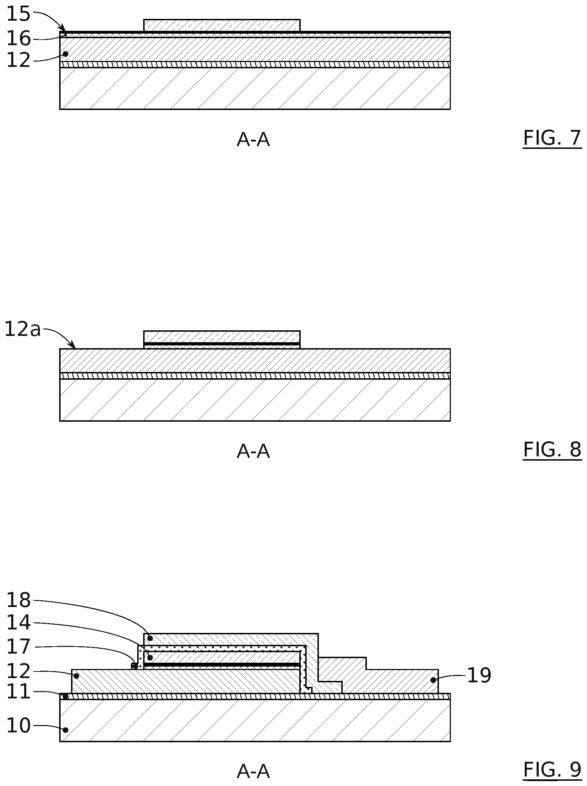

D'une manière générale, le système de stockage de l'invention, dont un exemple est visible en figure 9, comprend un empilement de couches permettant de réaliser les différents composants d'un organe de stockage électrochimique, comprenant un empilement comprenant lui-même un premier collecteur 12, 15, 16 (la couche 16 permettant de protéger le reste du premier collecteur de l'oxydation), une première électrode 14, un électrolyte 17, une deuxième électrode 18 et un deuxième collecteur 19. L'électrolyte est une portion intercalée entre les deux portions conductrices séparées et constituées respectivement du premier collecteur et de la première électrode, et de la deuxième électrode et du deuxième collecteur. Des échanges ioniques entre ces deux portions conductrices s'opèrent au travers de l'électrolyte, avantageusement solide, suivant le principe de stockage d'énergie électrochimique.

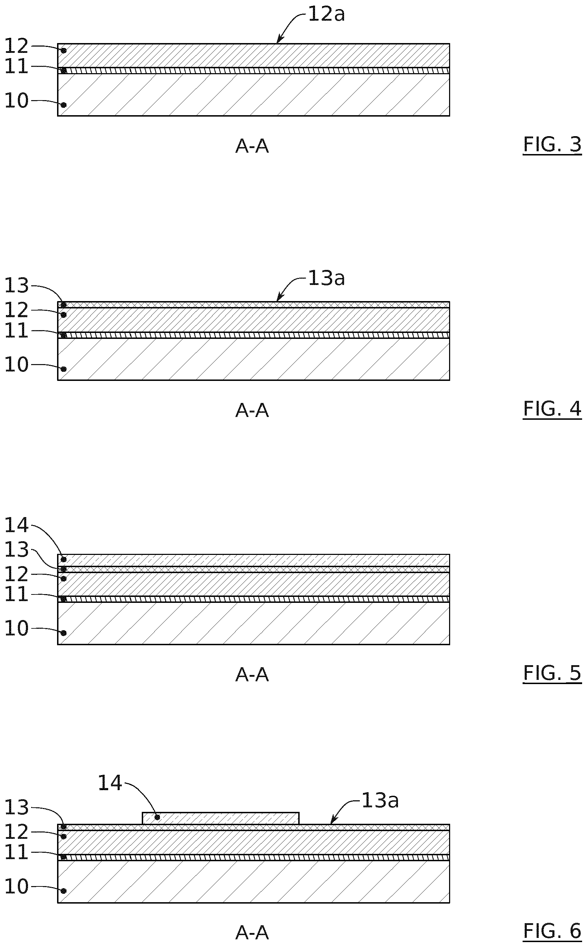

Pour parvenir au résultat de la figure 9, on décrit ci-après un procédé en suivant la chronologie des figures 3 à 8.

L'invention peut être mise en oeuvre sur la base d'un substrat 10 en tout matériau, et notamment ceux utilisés dans le domaine de la micro-électronique, par exemple des semi-conducteurs tels du silicium. Si le substrat 10 est de nature électriquement conductrice, on y adjoint de préférence une couche électriquement isolante 11 dont la face exposée va recevoir l'empilement constitutif du dispositif électrochimique. Ainsi, on a représenté en figure 3 une coupe transversale illustrant un tel substrat 10 avec une couche diélectrique 11 au-dessus de laquelle une première couche 12 de premier collecteur est formée. Typiquement, pour le dépôt de cette couche et, avantageusement pour le dépôt des autres couches de l'empilement, on peut utiliser une technique de dépôt physique en phase vapeur connue sous le vocable anglais PVD pour Physical Vapor Déposition. Tous les matériaux électriquement conducteurs peuvent convenir, comme Ti, Cu, W, MoSi ou d'un alliage FeCr, FeCrX (Al, Si, Ni ...), en étant avantageusement peu onéreux (notamment en évitant le platine). Par exemple, l'épaisseur de la première couche 12 de collecteur peut être supérieure ou égale à 50 nm, de préférence supérieure ou égale à 100 nm voire à 200 nm. Son épaisseur peut par exemple être inférieure ou égale à 2 microns. La résistivité électrique de cette partie peut être inférieure ou égale à 50.10⁻⁶ Ω.cm, de préférence inférieure ou égale à 30.10⁻⁶ Ω.cm est possiblement supérieure ou égale à 10.10⁻⁶ Ω.cm.

La face exposée 12a de la première couche 12 reçoit alors, telle que représentée à la figure 4, une deuxième couche 13 de collecteur. Dans l'exemple représenté, le recouvrement est complet, les dépôts étant opérés pleine plaque. Cependant, il n'est pas absolument nécessaire que la couche 13 recouvre intégralement la couche 12 ; en effet, ce recouvrement peut ne concerner qu'une zone de la première couche 12 de collecteur au regard de laquelle la première électrode sera située.

La deuxième couche 13 sert de protection contre l'oxydation. En effet ce matériau a le rôle d'empêcher l'oxydation du matériau de la couche de collecteur sous-jacente tout en gardant une conduction électronique. Ce matériau ne pourra donc pas être un isolant électrique mais peut être sélectionné dans les matériaux de type nitrure, oxyde conducteur électronique ou les matériaux formant une faible couche d'oxyde après oxydation. Il peut s'agir notamment de FeCrAl, FeCrAlN, TiAlN, CrN, Cr2-xN. Ce matériau sera d'une épaisseur la plus faible possible de manière à impacter faiblement la résistance interne du composant. Ainsi, avantageusement, l'épaisseur de la deuxième couche 13 est inférieure à celle de la première couche 12 ; par exemple, l'épaisseur de la couche 13 est inférieur à 30 nm voire à 20 nm (elle est possiblement supérieure à 5 nm). Avantageusement, la deuxième couche 13 est au moins cinq fois (et possiblement au moins dix fois) moins épaisse que la première couche 12. D'une manière générale, on peut utiliser comme matériau pour la deuxième couche 13 un matériau dont la résistivité électrique est supérieure à celle du matériau de la couche 12. Par exemple, on peut sélectionner un matériau présentant une résistivité électrique supérieure ou égale à 10⁶ Ω.cm. La faible épaisseur de la deuxième couche 13 permet de limiter l'accroissement de résistivité électrique du premier collecteur dans sa globalité. Par exemple, la résistance électrique induite par le deuxième collecteur peut être inférieure à 3 ohms.

On donne ci-après un tableau montrant quelques couples de matériaux de première couche et de deuxième couche de premier collecteur pouvant être utilisés :

| | Première couche 12 | Deuxième couche 13 |
|---|---|---|
| Cas 1 | Cu | FeCrAI |
| Cas 2 | Ti | Cr2-xN |
| Cas 3 | FeCrAl | FeCrAIN |
| Cas 4 | FeCrAl | Cr2-xN |

Vient ensuite la phase de formation de la première électrode, grâce au dépôt d'une couche de première électrode 14 comme illustrée à la figure 5. D'une manière générale, l'électrode positive peut-être du LICO (contraction du terme Lithium-Cobalt) ; elle peut être déposée par PVD, afin d'obtenir une épaisseur de couche notamment comprise entre 3 µm et 20 µm.

Une étape de photolithographie ainsi qu'une étape de gravure humide, permettent la réalisation d'un motif de première électrode 14, tel que représenté à la figure 6. Dans cette configuration, la face inférieure de la première électrode 14 est au contact de la face supérieure 13a de la deuxième couche 13 de premier collecteur ; le reste de la face supérieure 13a est exposé. La gravure s'effectue par exemple dans un bain de H₂SO₄/H₂O₂/H₂O (1/5/32), la vitesse de gravure étant de l'ordre de 6 µm/min.

Comme indiqué précédemment, la réalisation de la première électrode 14 impose, selon l'invention, un traitement thermique. À noter que ce dernier peut éventuellement être réalisé avant la mise en forme du motif de première électrode, soit avant l'étape illustrée à la figure 6. Le traitement thermique peut être un recuit sous atmosphère oxydante à une température supérieure ou égale à 300°C, possiblement supérieure ou égale à 500°C, voire supérieure ou égal à 700°C. À l'issue de ce traitement, la structure cristalline de la première électrode est fixée mais cela a aussi induit une modification du matériau de la deuxième couche 13 de premier collecteur, au niveau de sa face supérieure 13a, comme l'indique la figure 7 par la portion sombre référencée 15 surmontant une portion sous-jacente 16 non modifiée issue de la couche initiale 13. Il n'est pas absolument indispensable qu'une portion sous-jacente 16 subsiste : l'intégralité de l'épaisseur de la deuxième couche 13 peut être oxydée par exemple avec un traitement thermique sous air de 600°C pendant 2h pour un matériau de deuxième couche 13 constitué de 30nm de de Cr₂₋ₓN. Par contre, il convient de manière préférentielle que l'oxydation induite par le traitement thermique de l'électrode 14 n'affecte pas la première couche 12. Avantageusement, la couche 15 peut former un film de passivation protégeant la partie sous-jacente du premier collecteur. La couche 13 étant peu épaisse, la couche modifiée 15 est au maximum de la même épaisseur et de préférence plus fine, si bien que l'épaisseur de la couche 15 peut être en pratique de moins de 10nm, de sorte à ne pas influencer fortement la résistance électrique globale du collecteur.

L'étape de la figure 8 qui est facultative montre un enlèvement de la deuxième couche 13 à cette étape formée de la couche oxydée 15 et de la couche sous-jacente 16 dans les parties de la surface de l'empilement non recouvertes par la première électrode 14. Toute méthode de gravure courante peut être utilisée à cet effet. Cela permet notamment de raccorder électriquement le premier collecteur à un organe extérieur, par exemple un élément de reprise de contact, par l'intermédiaire uniquement du matériau de la première couche 12, par exemple par contact au niveau de la portion exposée de la face 12a de cette première couche, à nouveau facilement accessible et bénéficiant d'une résistivité électrique moindre que la deuxième couche de premier collecteur.

Par dépôt PVD notamment, l'électrolyte 17, de préférence du LiPON, ainsi que l'électrode négative 18 par exemple en silicium, et le deuxième collecteur 19 par exemple en Ti, vont être déposés successivement. Ces portions peuvent, à ce stade, être mises en forme. Par exemple, une photolithographie va permettre de localiser les futurs motifs de ces parties, qui vont être créés ensuite par un plasma notamment d'Ar/O₂/CHF₃, à 40T de pression, sous une puissance RF de 280W et une puissance LF de 400W (vitesse de gravure de l'ordre de 0.7 nm/min). La figure 9 en donne un résultat.

Sauf indication spécifique du contraire, des caractéristiques techniques décrites en détail pour un mode de réalisation donné peuvent être combinées à des caractéristiques techniques décrites dans le contexte d'autres modes de réalisation décrits à titre exemplaire et non limitatif, dont ceux expliqués en détail ci-dessus.

L'exemple donné en référence aux dessins s'inscrit dans le domaine du stockage d'énergie par voie électrochimique, en utilisant un électrolyte avantageusement sous forme de conducteur ionique solide. Néanmoins, d'autres dispositifs micro-électroniques sont concernés par la présente invention, en mettant en oeuvre des étapes équivalentes pour la fabrication du premier collecteur et de la première électrode, les étapes suivantes pouvant varier suivant l'application. Par exemple, l'invention peut être appliquée à des couches actives de nature électroactive, en particulier piézo-électriques dans des capteurs ou dans des actionneurs notamment. L'électrolyte est donc alors remplacé par une couche piézo-électrique ensuite recouverte de la deuxième électrode et du deuxième collecteur.

Outre la revue détaillée qui précède de modes de réalisation de l'invention, sont énoncées ci-après des caractéristiques optionnelles qui peuvent éventuellement être utilisées suivant toute association ou alternativement :
- le traitement thermique est configuré pour oxyder au plus l'épaisseur de la deuxième couche 13 de collecteur à partir de sa première face de sorte à former une couche d'oxyde 16 dans la deuxième couche 13 de collecteur, sans oxyder la partie recouverte.
- Avantageusement, le matériau de la deuxième couche 13 de collecteur est choisi moins oxydable que le matériau de la première couche 12 de collecteur.
- Optionnellement, la dimension en épaisseur de la première couche 12 de collecteur est choisie strictement supérieure à celle de la deuxième couche 13 de collecteur, et de préférence la première couche (12) est 4 à 6 fois plus grande que la deuxième couche (13).
- Selon un exemple non limitatif, l'épaisseur de la deuxième couche 13 de collecteur est inférieure ou égale à 20 nm.
- Préférentiellement, on choisit un matériau pour la deuxième couche 13 de collecteur présentant une résistivité électrique supérieure à celle du matériau de la première couche 12 de collecteur.
- Selon un mode de réalisation préféré, la deuxième couche 13 de collecteur est configurée pour former une couche de passivation pendant le traitement thermique.
- Avantageusement, le traitement thermique est une oxydation thermique, à une température supérieure ou égale à 300°C, et de préférence supérieure ou égale à 500°C.
- Avantageusement, la formation de la deuxième couche 13 de collecteur est configurée pour recouvrir totalement la première couche 12 de collecteur.
- De préférence, le procédé comprend un retrait de la deuxième couche 13 de collecteur, après la formation de la première électrode 14, sur au moins une partie de la deuxième couche de collecteur non recouverte par la première électrode 14.
- Selon un exemple, le procédé comprend après le traitement thermique, une formation d'une couche active au contact d'une face supérieure de la première électrode 14, une formation d'une deuxième électrode 18 au contact d'une face supérieure de la couche active et une formation d'un deuxième collecteur 19 en continuité électrique avec la deuxième électrode 18.

## Revendications

1. Procédé de réalisation d'un dispositif microélectronique comprenant successivement :
- une formation d'un premier collecteur de courant sur une face d'un substrat (10) ;
- une formation d'une première électrode (14) sur, et en continuité électrique avec, une portion du premier collecteur de courant ;
- un traitement thermique configuré pour traiter la première électrode (14)
**caractérisé par le fait que** :
- la formation du premier collecteur de courant comprend une formation d'une première couche (12) de collecteur sur la face du substrat et une formation d'une deuxième couche (13) de collecteur recouvrant au moins une partie, dite partie recouverte, de la première couche (12) de collecteur et présentant une première face au contact de la première électrode (14),
- la deuxième couche (13) de collecteur est configurée pour protéger la partie recouverte durant le traitement thermique, de sorte que le traitement thermique n'oxyde pas ladite partie recouverte.

2. Procédé selon la revendication précédente, dans lequel le traitement thermique est configuré pour oxyder au plus l'épaisseur de la deuxième couche (13) de collecteur à partir de sa première face de sorte à former une couche d'oxyde (16) dans la deuxième couche (13) de collecteur, sans oxyder la partie recouverte.

3. Procédé selon l'une des revendications précédentes, dans lequel le matériau de la deuxième couche (13) de collecteur est choisi moins oxydable que le matériau de la première couche (12) de collecteur.

4. Procédé selon l'une des revendications précédentes, dans lequel la dimension en épaisseur de la première couche (12) de collecteur est choisie strictement supérieure à celle de la deuxième couche (13) de collecteur, et de préférence la première couche (12) est 4 à 6 fois plus grande que la deuxième couche (13).

5. Procédé selon l'une des revendications précédentes, dans lequel l'épaisseur de la deuxième couche (13) de collecteur est inférieure ou égale à 20 nm.

6. Procédé selon l'une des revendications précédentes, dans lequel on choisit un matériau pour la deuxième couche (13) de collecteur présentant une résistivité électrique supérieure à celle du matériau de la première couche (12) de collecteur.

7. Procédé selon l'une des revendications précédentes, dans lequel la deuxième couche (13) de collecteur est configurée pour former une couche de passivation pendant le traitement thermique.

8. Procédé selon l'une des revendications précédentes, dans lequel le traitement thermique est une oxydation thermique, à une température supérieure ou égale à 300°C, et de préférence supérieure ou égale à 500°C.

9. Procédé selon l'une des revendications précédentes, dans lequel la formation de la deuxième couche (13) de collecteur est configurée pour recouvrir totalement la première couche (12) de collecteur.

10. Procédé selon l'une des revendications précédentes, comprenant un retrait de la deuxième couche (13) de collecteur, après la formation de la première électrode (14), sur au moins une partie de la deuxième couche de collecteur non recouverte par la première électrode (14).

11. Procédé selon l'une des revendications précédentes, comprenant, après le traitement thermique, une formation d'une couche active solide au contact d'une face supérieure de la première électrode (14), une formation d'une deuxième électrode (18) au contact d'une face supérieure de la couche active solide et une formation d'un deuxième collecteur (19) en continuité électrique avec la deuxième électrode (18).

12. Dispositif microélectronique réalisé par le procédé selon l'une des revendications 1 à 11, le dispositif comprenant en empilement sur une face d'un substrat un premier collecteur de courant, une première électrode (14), une couche active solide, une deuxième électrode (18) et un deuxième collecteur (19) de courant, **caractérisé par le fait que** le premier collecteur comprend une première couche (12) de collecteur au contact de la face du substrat et une deuxième couche (13) de collecteur recouvrant au moins une partie, dite partie recouverte, de la première couche (12) de collecteur et présentant une première face au contact de la première électrode (14) et en ce que la deuxième couche (13) de collecteur est configurée pour protéger la partie recouverte contre l'oxydation.

13. Dispositif selon la revendication 12, dans lequel la deuxième couche (13) de collecteur comprend une couche d'oxyde (16) suivant au moins une partie de son épaisseur à partir de sa première face.

14. Dispositif selon l'une des revendications 12 ou 13, dans lequel la résistivité électrique du matériau de la deuxième couche (13) de collecteur est supérieure à la résistivité électrique de la première couche (12) de collecteur.

15. Dispositif selon l'une des revendications 12, 13 ou 14, dans lequel la couche active comprend une couche d'électrolyte (17) ou une couche piézoélectrique.

## Patentansprüche

1. Verfahren zur Herstellung einer mikroelektronischen Vorrichtung, das nacheinander umfasst:
- ein Bilden eines ersten Stromkollektors auf einer Seite eines Substrats (10);
- ein Bilden einer ersten Elektrode (14) auf, und in elektrischer Kontinuität mit, einem Abschnitt des ersten Stromkollektors;
- eine thermische Behandlung, die dafür konfiguriert ist, die erste Elektrode (14) zu behandeln,
**dadurch gekennzeichnet, dass**:
- das Bilden des ersten Stromkollektors ein Bilden einer ersten Kollektorschicht (12) auf der Seite des Substrats und ein Bilden einer zweiten Kollektorschicht (13) umfasst, die mindestens einen als bedeckter Teil bezeichneten Teil der ersten Kollektorschicht (12) bedeckt und eine erste Seite in Kontakt mit der ersten Elektrode (14) aufweist,
- die zweite Kollektorschicht (13) so konfiguriert ist, dass sie den bedeckten Teil während der thermischen Behandlung so schützt, dass die thermische Behandlung den bedeckten Teil nicht oxidiert.

2. Verfahren nach dem vorstehenden Anspruch, wobei die thermische Behandlung so konfiguriert ist, dass sie höchstens die Dicke der zweiten Kollektorschicht (13) ab ihrer ersten Seite oxidiert, um in der zweiten Kollektorschicht (13) eine Oxidschicht (16) zu bilden, ohne den bedeckten Teil zu oxidieren.

3. Verfahren nach einem der vorstehenden Ansprüche, wobei das Material der zweiten Kollektorschicht (13) so ausgewählt ist, dass es weniger oxidierbar ist als das Material der ersten Kollektorschicht (12).

4. Verfahren nach einem der vorstehenden Ansprüche, wobei die Dickenabmessung der ersten Kollektorschicht (12) so ausgewählt ist, dass sie streng größer ist als diejenige der zweiten Kollektorschicht (13), und die erste Schicht (12) vorzugsweise 4- bis 6-mal größer ist als die zweite Schicht (13).

5. Verfahren nach einem der vorstehenden Ansprüche, wobei die Dicke der zweiten Kollektorschicht (13) kleiner oder gleich 20 nm ist.

6. Verfahren nach einem der vorstehenden Ansprüche, wobei für die zweite Kollektorschicht (13) ein Material ausgewählt wird, das einen spezifischen elektrischen Widerstand aufweist, der größer ist als derjenige des Materials der ersten Kollektorschicht (12).

7. Verfahren nach einem der vorstehenden Ansprüche, wobei die zweite Kollektorschicht (13) so konfiguriert ist, dass sie während der thermischen Behandlung eine Passivierungsschicht bildet.

8. Verfahren nach einem der vorstehenden Ansprüche, wobei es sich bei der thermischen Behandlung um eine thermische Oxidation bei einer Temperatur von größer oder gleich 300 °C, und vorzugsweise größer oder gleich 500 ° handelt.

9. Verfahren nach einem der vorstehenden Ansprüche, wobei das Bilden der zweiten Kollektorschicht (13) so konfiguriert ist, dass die erste Kollektorschicht (12) vollständig bedeckt wird.

10. Verfahren nach einem der vorstehenden Ansprüche, das nach dem Bilden der ersten Elektrode (14) ein Entfernen der zweiten Kollektorschicht (13) auf mindestens einem Teil der zweiten Kollektorschicht umfasst, der nicht von der ersten Elektrode (14) bedeckt wird.

11. Verfahren nach einem der vorstehenden Ansprüche, das nach der thermischen Behandlung ein Bilden einer festen aktiven Schicht in Kontakt mit einer oberen Seite der ersten Elektrode (14), ein Bilden einer zweiten Elektrode (18) in Kontakt mit einer oberen Seite der festen aktiven Schicht, und ein Bilden eines zweiten Kollektors (19) in elektrischer Kontinuität mit der zweiten Elektrode (18) umfasst.

12. Mikroelektronische Vorrichtung, die über das Verfahren nach einem der Ansprüche 1 bis 11 hergestellt ist, wobei die Vorrichtung auf einer Seite eines Substrats gestapelt einen ersten Stromkollektor, eine erste Elektrode (14), eine feste aktive Schicht, eine zweite Elektrode (18) und einen zweiten Stromkollektor (19) umfasst, **dadurch gekennzeichnet, dass** der erste Kollektor eine erste Kollektorschicht (12) in Kontakt mit der Seite des Substrats, und eine zweite Kollektorschicht (13) umfasst, die mindestens einen als bedeckter Teil bezeichneten Teil der ersten Kollektorschicht (12) bedeckt und eine erste Seite in Kontakt mit der ersten Elektrode (14) aufweist, und dadurch, dass die zweite Kollektorschicht (13) so konfiguriert ist, dass sie den bedeckten Teil vor Oxidation schützt.

13. Vorrichtung nach Anspruch 12, wobei die zweite Kollektorschicht (13) ab ihrer ersten Seite entlang mindestens eines Teils ihrer Dicke eine Oxidschicht (16) umfasst.

14. Vorrichtung nach einem der Ansprüche 12 oder 13, wobei der spezifische elektrische Widerstand des Materials der zweiten Kollektorschicht (13) größer ist als der spezifische elektrische Widerstand der ersten Kollektorschicht (12).

15. Vorrichtung nach einem der Ansprüche 12, 13 oder 14, wobei die aktive Schicht eine Elektrolytschicht (17) oder eine piezoelektrische Schicht umfasst.

## Claims

1. Method for producing a microelectronic device successively comprising:
- forming a first current collector on a face of a substrate (10);
- forming a first electrode (14) on, and in electrical continuity with, a portion of the first current collector;
- a heat treatment configured to heat treat the first electrode (14)
**characterised in that**:
- the formation of the first current collector comprises forming a first collector layer (12) on the face of the substrate and forming a second collector layer (13) covering at least one part, referred to as a covered part, of the first collector layer (12) and having a first face in contact with the first electrode (14),
- the second collector layer (13) is configured to protect the covered part during the heat treatment, such that the heat treatment does not oxidise said covered part.

2. Method according to the preceding claim, wherein the heat treatment is configured to oxidise, at most, the thickness of the second collector layer (13) from the first face thereof so as to form an oxide layer (16) in the second collector layer (13), without oxidising the covered part.

3. Method according to one of the preceding claims, wherein the material of the second collector layer (13) is selected such that it is less oxidisable than the material of the first collector layer (12).

4. Method according to one of the preceding claims, wherein the thickness dimension of the first collector layer (12) is selected such that it is strictly greater than that of the second collector layer (13), and preferably the first layer (12) is 4 to 6 times greater than the second layer (13).

5. Method according to one of the preceding claims, wherein the thickness of the second collector layer (13) is less than or equal to 20 nm.

6. Method according to one of the preceding claims, wherein a material is selected for the second collector layer (13) that has an electrical resistivity greater than that of the material of the first collector layer (12).

7. Method according to one of the preceding claims, wherein the second collector layer (13) is configured to form a passivation layer during the heat treatment.

8. Method according to one of the preceding claims, wherein the heat treatment is a thermal oxidation, at a temperature greater than or equal to 300°C, and preferably greater than or equal to 500°C.

9. Method according to one of the preceding claims, wherein the formation of the second collector layer (13) is configured to cover the first collector layer (12) in full.

10. Method according to one of the preceding claims, comprising removing the second collector layer (13), after the formation of the first electrode (14), over at least one part of the second collector layer not covered by the first electrode (14).

11. Method according to one of the preceding claims, comprising, after the heat treatment, forming a solid active layer in contact with a top face of the first electrode (14), forming a second electrode (18) in contact with a top face of the solid active layer, and forming a second collector (19) in electrical continuity with the second electrode (18).

12. Microelectronic device produced using the method according to one of claims 1 to 11, the device comprising, in a stack on one face of a substrate, a first current collector, a first electrode (14), a solid active layer, a second electrode (18) and a second current collector (19), **characterised in that** the first collector comprises a first collector layer (12) in contact with the face of the substrate and a second collector layer (13) covering at least one part, referred to as a covered part, of the first collector layer (12) and having a first face in contact with the first electrode (14) and **in that** the second collector layer (13) is configured to protect the covered part from oxidation.

13. Device according to claim 12, wherein the second collector layer (13) comprises an oxide layer (16) through at least one part of the thickness thereof from the first face thereof.

14. Device according to one of claims 12 or 13, wherein the electrical resistivity of the material of the second collector layer (13) is greater than the electrical resistivity of the first collector layer (12).

15. Device according to one of claims 12, 13 or 14, wherein the active layer comprises an electrolyte layer (17) or a piezoelectric layer.
